(19) Europäisches Patentamt
European Patent Office
Office européen des brevets

(11) **EP 4 286 870 B1**

(12) **EUROPEAN PATENT SPECIFICATION**

(45) Date of publication and mention
of the grant of the patent:
**29.04.2026 Bulletin 2026/18**

(21) Application number: **22849859.8**

(22) Date of filing: **26.07.2022**

(51) International Patent Classification (IPC):
**G01R 31/392** (2019.01)    **G01R 31/382** (2019.01)
**G01R 31/52** (2020.01)    **G01R 19/00** (2006.01)
**G01R 31/36** (2020.01)    **H02J 7/00** (2026.01)
**G01R 31/396** (2019.01)

(52) Cooperative Patent Classification (CPC):
**H02J 7/80; G01R 31/392; G01R 31/396; H02J 7/52;**
G01R 31/3835; G01R 31/52; H02J 7/54; H02J 7/60;
H02J 2105/37; Y02E 60/10

(86) International application number:
**PCT/KR2022/010982**

(87) International publication number:
**WO 2023/008883 (02.02.2023 Gazette 2023/05)**

(54) **BATTERY MANAGEMENT SYSTEM, BATTERY PACK, ELECTRIC VEHICLE, AND BATTERY MANAGEMENT METHOD**

BATTERIEVERWALTUNGSSYSTEM, BATTERIEPACK, ELEKTROFAHRZEUG UND BATTERIEVERWALTUNGSVERFAHREN

SYSTÈME DE GESTION DE BATTERIE, BLOC-BATTERIE, VÉHICULE ÉLECTRIQUE ET PROCÉDÉ DE GESTION DE BATTERIE

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **26.07.2021 KR 20210098141**

(43) Date of publication of application:
**06.12.2023 Bulletin 2023/49**

(60) Divisional application:
**26165255.6**

(73) Proprietor: **LG Energy Solution, Ltd.**
**Seoul 07335 (KR)**

(72) Inventors:
• **PARK, Hee-Ju**
**Daejeon 34122 (KR)**
• **KIM, Cheol-Taek**
**Daejeon 34122 (KR)**
• **SUNG, Yong-Chul**
**Daejeon 34122 (KR)**

(74) Representative: **Plasseraud IP**
**104 Rue de Richelieu**
**CS92104**
**75080 Paris Cedex 02 (FR)**

(56) References cited:
EP-A1- 3 829 023        WO-A1-2020/021889
JP-A- 2019 176 637      KR-A- 20140 113 401
KR-A- 20210 031 172     KR-B1- 101 629 648
KR-B1- 101 946 288      US-A1- 2019 277 923

• **KANG YONGZHE ET AL: "Online multi-fault detection and diagnosis for battery packs in electric vehicles", APPLIED ENERGY, ELSEVIER SCIENCE PUBLISHERS, GB, vol. 259, 30 November 2019 (2019-11-30), XP085975508, ISSN: 0306-2619, [retrieved on 20191130], DOI: 10.1016/J.APENERGY.2019.114170**

**Description**

TECHNICAL FIELD

The present disclosure relates to internal short circuit fault detection of battery.

The present application claims the benefit of Korean Patent Application No. 10-2021-0098141 filed on July 26, 2021 with the Korean Intellectual Property Office.

BACKGROUND ART

Recently, there has been a rapid increase in the demand for portable electronic products such as laptop computers, video cameras and mobile phones, and with the development of electric vehicles, batteries for energy storage, robots and satellites, many studies are being made on high performance batteries that can be repeatedly recharged.

Currently, commercially available batteries include nickel-cadmium batteries, nickel-hydrogen batteries, nickel-zinc batteries, lithium batteries and the like, and among them, lithium batteries have little or no memory effect, and thus they are gaining more attention than nickel-based batteries for their advantages that recharging can be done whenever it is convenient, the self-discharge rate is very low and the energy density is high.

To meet the high voltage and high capacity requirements of applications such as electric vehicles, a battery system (for example, a battery pack) including at least one battery group (i.e., a series connection structure of batteries) is widespread.

In the battery system, there is a high possibility that a fault in a certain battery will adversely affect the overall performance and safety of the battery system. Accordingly, in the management of the battery system, it is important to accurately detect a fault in the individual battery.

There may be differences in characteristics between batteries due to the internal/external factors in the manufacturing process and/or while in use. The differences in characteristics between batteries cause voltage imbalances. A balancer is widely used to mitigate the voltage imbalances between batteries by performing the balancing (for example, discharging) operation for each battery.

Meanwhile, among battery fault types, an internal short circuit fault is the main fault that directly/indirectly affects fires. The internal short circuit fault occurs when a path of a leakage current is formed by side reactions in batteries and/or infiltration of impurities into batteries. The voltage imbalances between batteries have been used to detect a battery in an internal short circuit fault among the batteries.

However, when the balancing operation is performed, the voltage imbalances between batteries which are important information for the internal short circuit fault detection are mitigated. That is, in the detection of the battery in an internal short circuit fault among the batteries, the balancing operation performed in the past acts as a hindering factor.

WO2020/021889 A1, EP3829023 A1, JP2019 176637 A and Kang Yongzhe et al "Online multi-fault detection and diagnosis for battery packs in electric vehicles", Applied Energy, Elsevier Science publishers, GB, vol. 259, 30 November 2019 (2019-11-30), ISSN: 0306-2619, DOI: 10.1016/J. APENERGY.2019.114170 each relate to performing balancing processes in battery packs including a plurality of cells.

DISCLOSURE

Technical Problem

The present disclosure is designed to solve the above-described problem, and therefore the present disclosure is directed to providing a battery management system, a battery pack, an electric vehicle and a battery management method for accurately detecting a battery in an internal short circuit fault among batteries in the absence of voltage imbalances between the batteries by the balancing operation.

These and other objectives and advantages of the present disclosure may be understood by the following description and will be apparent from an embodiment of the present disclosure. In addition, it will be readily understood that the objectives and advantages of the present disclosure may be realized by the means set forth in the appended claims.

Technical Solution

The present invention is defined by a battery management system according to claim 1.

The control circuit may be configured to increase a fault count of each battery by 1 when the change amount of the voltage deviation of each battery is equal to or larger than the threshold. The control circuit is configured to detect the internal short circuit fault in each battery when the fault count of each battery is equal to or larger than a predetermined value.

The control circuit may be configured to determine the reference voltage value to be equal to an average or median of the compensated first voltage values of at least two of the plurality of batteries.

The balancer may include a plurality of balancing circuits connected in parallel to the plurality of batteries in a one-to-one correspondence relationship. Each balancing circuit includes a discharge resistor and a discharge switch connected in series.

The control circuit may be configured to determine the balancing capacity of each battery by accumulating the discharge capacity of each battery by each balancing operation within a period of the reference time.

The control circuit may be configured to determine the discharge capacity of each battery by each balancing operation by applying a capacity estimation function to first balancing data associated with each balancing operation. The first balancing data includes a second voltage value indicating the no-load voltage of each battery at a start of the balancing operation and a duration of the balancing operation.

The control circuit may be configured to determine the discharge capacity of each battery by each balancing operation by applying a state of charge (SOC)-open circuit voltage (OCV) map to second balancing data of each balancing operation. The second balancing data includes a second voltage value indicating the no-load voltage of each battery at a start of the balancing operation and a third voltage value indicating the no-load voltage of each battery at an end of the balancing operation.

The control circuit may be configured to determine an estimated SOC of each battery by applying a SOC-OCV map to the first voltage value of each battery. The control circuit may be configured to compensate the estimated SOC of each battery by adding a SOC change amount corresponding to the balancing capacity to the estimated SOC of each battery. The control circuit may be configured to determine the compensated first voltage value by applying the SOC-OCV map to the compensated estimated SOC of each battery.

A battery pack according to another aspect of the present disclosure includes the battery management system.

An electric vehicle according to still another aspect of the present disclosure includes the battery pack.

The present invention is defined by a battery management method according to claim 11.

The step of detecting the internal short circuit fault in each battery may include increasing a fault count of each battery by 1 when the change amount of the voltage deviation of each battery is equal to or larger than the threshold; and detecting the internal short circuit fault in each battery when the fault count of each battery is equal to or larger than a predetermined value.

The battery management method may further include determining the reference voltage value to be equal to an average or median of the compensated first voltage values of at least two of the plurality of batteries.

The step of compensating the first voltage value of each battery may include determining an estimated SOC of each battery by applying a SOC-OCV map to the first voltage value of each battery; compensating the estimated SOC of each battery by adding a SOC change amount corresponding to the balancing capacity to the estimated SOC of each battery; and determining the compensated first voltage value by applying the SOC-OCV map to the compensated estimated SOC of each battery.

Advantageous Effects

According to at least one of the embodiments of the present disclosure, it is possible to accurately detect a battery in an internal short circuit fault among batteries in the absence of voltage imbalances between the batteries by the balancing operation.

The effects of the present disclosure are not limited to the above-mentioned effects, and these and other effects will be clearly understood by those skilled in the art from the appended claims.

DESCRIPTION OF DRAWINGS

The accompanying drawings illustrate an exemplary embodiment of the present disclosure, and together with the detailed description of the present disclosure as described below, serve to provide a further understanding of the technical aspects of the present disclosure, and thus the present disclosure should not be construed as being limited to the drawings.

FIG. 1 is a diagram exemplarily showing an electric vehicle according to the present FIG. 1 shows a battery management system 100 according to the invention.

FIG. 2 is a diagram for reference in describing an exemplary equivalent circuit of a battery.

FIGS. 3 to 6 are diagrams for reference in describing the principle of internal short circuit fault detection in a battery.

FIGS. 7 and 8 are flowcharts exemplarily showing a battery management method FIG. 7 shows a battery management method according to the invention.

FIG. 9 is a flowchart exemplarily showing a battery management method according to a second embodiment of the present disclosure.

## BEST MODE

Hereinafter, exemplary embodiments of the present disclosure will be described in detail with reference to the accompanying drawings. Prior to the description, it should be understood that the terms or words used in the specification and the appended claims should not be construed as being limited to general and dictionary meanings, but rather interpreted based on the meanings and concepts corresponding to the technical aspects of the present disclosure on the basis of the principle that the inventor is allowed to define the terms appropriately for the best explanation.

Therefore, the embodiments described herein and the illustrations shown in the drawings are just an exemplary embodiment of the present disclosure, but not intended to fully describe the technical aspects of the present disclosure, so it should be understood that a variety of other equivalents and modifications could have been made thereto at the time that the application was filed.

The terms including the ordinal number such as "first", "second" and the like, are used to distinguish one element from another among various elements, but not intended to limit the elements.

Unless the context clearly indicates otherwise, it will be understood that the term "comprises" when used in this specification, specifies the presence of stated elements, but does not preclude the presence or addition of one or more other elements. Additionally, the term "control unit" as used herein refers to a processing unit of at least one function or operation, and may be implemented in hardware and software either alone or in combination.

In addition, throughout the specification, it will be further understood that when an element is referred to as being "connected to" another element, it can be directly connected to the other element or intervening elements may be present.

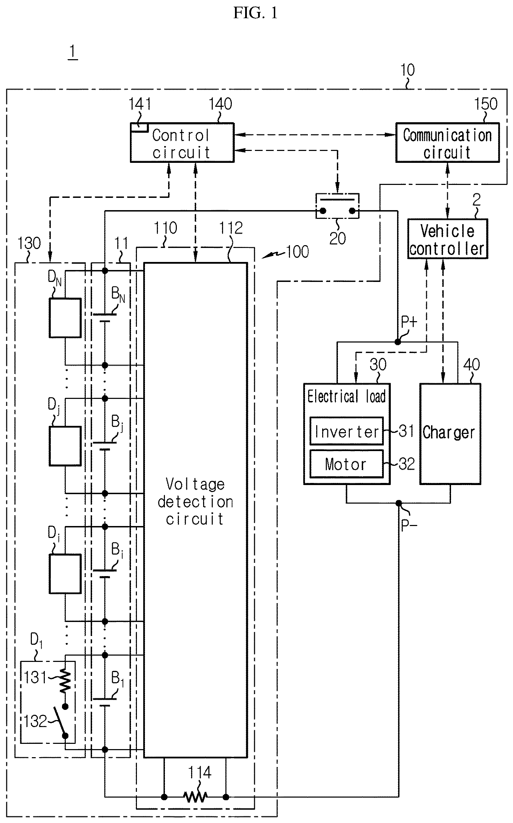

FIG. 1 is a diagram showing exemplarily an electric vehicle according to the present disclosure.

Referring to FIG. 1, the electric vehicle 1 includes a vehicle controller 2, a battery pack 10 and an electrical load 30. Charge/discharge terminals P+, P- of the battery pack 10 may be electrically coupled to a charger 40 through a charging cable. The charger 40 may be included in the electric vehicle 1, or provided in a charging station outside of the electric vehicle 1.

The vehicle controller 2 (for example, an Electronic Control Unit (ECU)) is configured to transmit a key-on signal to the battery management system 100 in response to an ignition button (not shown) of the electric vehicle 1 being switched to an ON-position by a user. The vehicle controller 2 is configured to transmit a key-off signal to the battery management system 100 in response to the ignition button being switched to an OFF-position by the user. The charger 40 may communicate with the vehicle controller 2 and may supply charge power (for example, constant current, constant voltage, constant power) through the charge/discharge terminals P+, P-of the battery pack 10.

The battery pack 10 includes a battery group 11, a relay 20 and a battery management system 100.

The battery group 11 includes a series connection structure of batteries $B_1$-$B_N$ (N is a natural number of 2 or greater). That is, in the battery group 11, the batteries $B_1{\sim}B_N$ are connected in series. The batteries $B_1$-$B_N$ may include a unit cell having the same electrical and chemical specification or two or more units cells connected either in series or in parallel or both. The unit cell is a minimum unit of an energy storage element that can be independently charged and discharged. For example, the unit cell is not limited to a particular type and may include any type of cell that can be repeatedly charged and discharged, such as lithium ion cells.

Hereinafter, in the common description of the batteries $B_1{\sim}B_N$, the symbol 'B' is affixed to the battery.

The relay 20 is electrically connected in series to the battery group 11 through the power path connecting the battery group 11 and the electrical load 30. FIG. 1 shows that the relay 20 is connected between the positive terminal of the battery group 11 and one terminal P+ of the charge/discharge terminals. The on/off control of the relay 20 is performed in response to a switching signal from the battery management system 100 and/or the vehicle controller 2. The relay 20 may be a mechanical contactor that is turned on/off by the magnetic field of the coil or a semiconductor switch such as Metal Oxide Semiconductor Field Effect transistor (MOSFET).

The electrical load 30 includes an inverter 31 and an electric motor 32. The inverter 31 is provided to convert the direct current power from the battery group 11 included in the battery pack 10 to alternating current power in response to a command from the battery management system 100 or the vehicle controller 2. The electric motor 32 operates using the alternating current power from the inverter 31. The electric motor 32 may include, for example, a 3-phase alternating current motor.

When the relay 20 turns on and the battery B is charged/discharged, it is referred to as load condition (cycling condition).

When the relay 20 is switched from on to off, the battery B is in a no-load condition (rest, calendar), and a battery voltage of the battery B in the no-load condition may be referred to as a no-load voltage. The no-load voltage refers collectively to a relaxation voltage and an open circuit voltage (OCV). Specifically, when the battery B is changed from the load condition to the no-load condition, the no-load voltage of the battery B changes with reduced polarization in the battery B. The OCV indicates the no-load voltage when the voltage change of the battery B is less than a predetermined value as the battery B is kept in no-load condition for a predetermined time (for example, 2 hours) or more. That is, the OCV is the no-load voltage when the polarization of the battery B is negligible. The relaxation voltage indicates the no-load voltage with reduced polarization.

The battery management system 100 may include a battery monitor 110, a balancer 130 and a control circuit 140. The battery management system 100 may further include a communication circuit 150. Hereinafter, assume that the battery management system 100 includes the battery monitor 110, the control circuit 140 and the communication circuit 150.

The battery monitor 110 includes a voltage detection circuit 112. The battery monitor 110 may further include a current detector 114.

The voltage detection circuit 112 is connected to the positive and negative terminals of each of the batteries $B_1 \sim B_N$ included in the battery group 11, and is configured to detect a voltage (referred to as a battery voltage) across the battery B and generate a voltage signal indicating the detected battery voltage.

The current detector 114 is connected in series to the battery group 11 through the current path between the battery group 11 and the inverter 31. The current detector 114 may include at least one of known current detection devices such as a shunt resistor and a hall effect device. Since the batteries $B_1 \sim B_N$ are connected in series, the common charge/discharge current flows in the batteries $B_1$-$B_N$.

FIG. 1 shows the shunt resistor used for the current detector 114. In this case, the voltage detection circuit 112 may output a current signal indicating the direction and magnitude of the charge/discharge current to the control circuit 140 based on the voltage across the shunt resistor. The current detector 114 may directly generate the current signal indicating the charge/discharge current flowing through the battery group 11 and output it to the control circuit 140.

The balancer 130 is configured to perform a balancing operation on the battery B that needs to be balanced among the batteries $B_1 \sim B_N$ in response to a balancing command from the control circuit 140. Hereinafter, the battery B determined to be balanced is referred to as a 'target battery'. The balancing command may include a target time for the target battery B among the batteries $B_1$-$B_N$. The target time refers to a balancing duration required for the target battery B.

FIG. 1 shows an example of the balancer 130 including balancing circuits $D_1$-$D_N$. The balancing circuits $D_1 \sim D_N$ may be connected in parallel to the batteries $B_1 \sim B_N$ in a one-to-one correspondence relationship. Hereinafter, in the common description of the balancing circuits $D_1 \sim D_N$, the symbol 'D' is affixed to the battery.

The balancing circuit D is a series circuit of a discharge resistor 131 and a discharge switch 132. The discharge switch 132 is turned on in response to the balancing command. While the discharge switch 132 is turned on, the battery B is discharged by the discharge resistor 131. The discharge switch 132 may be a semiconductor switch such as MOSFET.

The control circuit 140 may be operably coupled to the relay 20, the battery monitor 110, the balancer 130 and the communication circuit 150. Operably coupled refers to connected directly/indirectly to transmit and receive a signal in one or two directions.

The control circuit 140 may be referred to as a 'battery controller', and may be implemented in hardware using at least one of digital signal processors (DSPs), digital signal processing devices (DSPDs), programmable logic devices (PLDs), field programmable gate arrays (FPGAs), microprocessors or electrical units for performing the other functions.

The control circuit 140 may collect the voltage signal and/or the current signal from the battery monitor 110. In an example, the control circuit 140 may convert and record the analog signal collected from the battery monitor 110 to a digital value using an Analog to Digital Converter (ADC) provided therein. Alternatively, the battery monitor 110 itself may transmit the result of converting the analog signal to the digital value to the control circuit 140.

Memory 141 may include, for example, at least one type of storage medium of flash memory type, hard disk type, Solid State Disk (SSD) type, Silicon Disk Drive (SDD) type, multimedia card micro type, random access memory (RAM), static random access memory (SRAM), read-only memory (ROM), electrically erasable programmable read-only memory (EEPROM) or programmable read-only memory (PROM). The memory 141 may store data and programs required for the computational operation by the control circuit 140. The memory 141 may store data indicating the result of the computational operation by the control circuit 140. The memory 141 may store given functions, logics and algorithms to use them to detect an internal short circuit fault in the battery B. The memory 141 may be integrated into the control circuit 140.

The control circuit 140 may turn on the relay 20 in response to the key-on signal from the vehicle controller 2. The control circuit 140 may turn off the relay 20 in response to the key-off signal from the vehicle controller 2. The key-on signal is a signal that requests the switch from the no-load condition to the load condition. The key-off signal is a signal that requests the switch from the load condition to the no-load condition. Alternatively, instead of the control circuit 140, the vehicle controller 2 may be responsible for the on/off control of the relay 20.

The control circuit 140 is configured to control the balancer 130 based on the voltage of the battery B detected by the battery monitor 110.

The control circuit 140 may identify the maximum voltage and the minimum voltage of the batteries $B_1 \sim B_N$ by monitoring the voltage of each battery $B_1 \sim B_N$. The maximum voltage is the highest one of the voltages of the batteries $B_1 \sim B_N$. The minimum voltage is the lowest one of the voltages of the batteries $B_1 \sim B_N$.

The communication circuit 150 is configured to support wired or wireless communication between the control circuit 140 and the vehicle controller 2. The wired communication may be, for example, controller area network (CAN) communication, and the wireless communication may be, for example, Zigbee or Bluetooth communication. The communication protocol is not limited to a particular type and may include any type of communication protocol that supports wired/wireless communication between the control circuit 140 and the vehicle controller 2. The communication circuit 150 may include an output device (for example, a display, a speaker) to provide information received from the control circuit 140 and/or the vehicle controller 2 into a recognizable format for the user (a driver).

Hereinafter, the operations performed by the control circuit 140 to detect an internal short circuit fault in the battery will be described in detail.

The control circuit 140 determines a voltage value of the no-load voltage of the battery B.

When the battery B is in the no-load condition, the control circuit 140 may determine the voltage value of the no-load voltage of the battery B to be equal to the voltage value of the voltage of the battery B detected by the battery monitor 110.

When the battery B is in the load condition, the control circuit 140 may determine (estimate) the voltage value of the no-load voltage of the battery B based on the battery voltage of the battery B detected by the battery monitor 110 and the charge/discharge current of the battery B detected by the current detector 114 using a battery state estimation algorithm. In an example, according to the Ohm's law, the no-load voltage of the battery B may be estimated by subtracting the voltage corresponding to the multiplication of the charge/discharge current of the battery B by the internal resistance of the battery B from the battery voltage of the battery B detected by the battery monitor 110.

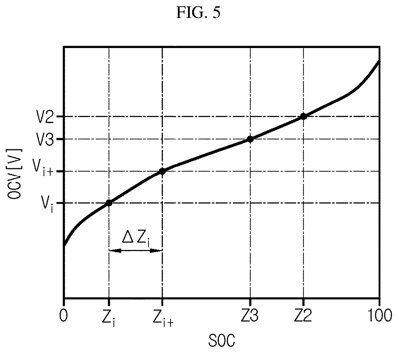

Alternatively, irrespective of whether the battery B is in the no-load condition or the load condition, the control circuit 140 may determine an estimated State Of Charge (SOC) of the battery B using the predetermined battery state estimation algorithm, and acquire a value of OCV associated with the estimated SOC of the battery B from a given SOC-OCV map (see FIG. 5). The battery state estimation algorithm may include the known algorithms (for example, the Kalman filter).

The control circuit 140 determines the target battery B among the batteries $B_1 \sim B_N$. When the battery group 11 is changed from the load condition to the no-load condition, the control circuit 140 may determine whether the balancing operation for at least one of batteries $B_1 \sim B_N$ is necessary or not. The determination as to the presence or absence of the target battery B may be periodically performed while in the no-load condition from the time when the battery group 11 is changed from the load condition to the no-load condition, i.e., from the start of the no-load condition.

In an example, the control circuit 140 may set, as the target battery, the battery B of which the no-load voltage is higher than the minimum no-load voltage of the batteries $B_1 \sim B_N$ by a reference value or more. In another example, the control circuit 140 may set, as the target battery, the battery B of which the estimated SOC is higher than the minimum SOC of the batteries $B_1 \sim B_N$ by a reference value or more.

The control circuit 140 may determine a target capacity of the target battery B to be equal to capacity corresponding to a difference in voltage (or a difference in SOC) between the target battery (for example, $B_i$) and a reference battery (for example, $B_j$). The reference battery refers to a battery corresponding to the minimum no-load voltage (or the minimum SOC) among the batteries $B_1 \sim B_N$. The control circuit 140 may determine the target time for the target battery B using a given map as a correlation between the target capacity and the target time. The correlation between the target capacity and the target time may be determined through experiments performed on batteries having the same electrical and chemical performance as the battery B.

Alternatively, each time the balancing command is received, the balancer 130 may perform the balancing operation on the target battery B for a first time, and stop the balancing operation for a second time. Every time when the balancing operation of the balancer 130 is stopped, the control circuit 140 may identify the target battery B again among the batteries $B_1 \sim B_N$, and transmit the balancing command for the target battery B to the balancer 130.

The balancing command may be a high level voltage that is directly applied to the discharge switch 132 to induce the discharge switch 132 from off to on. The discharge switch 132 may be kept off while the balancing command is not received.

Meanwhile, when a switch from the no-load condition to load condition is requested during the balancing operation for the target battery B, the control circuit 140 may output a balancing stop command to the balancer 130. The balancer 130 may terminate the balancing operation for all the batteries $B_1 \sim B_N$ in response to the balancing stop command.

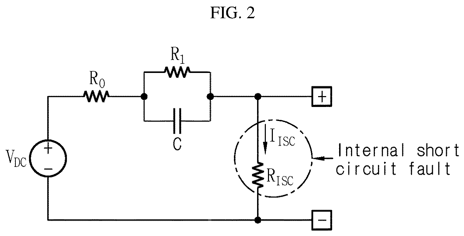

FIG. 2 is a diagram for reference in describing an exemplary equivalent circuit of the battery. In the specification, a normal battery refers to a battery free of an internal short circuit fault among the batteries $B_1 \sim B_N$, and a faulty battery refers to a battery in an internal short circuit fault among the batteries $B_1 \sim B_N$.

Referring to FIG. 2, the normal battery may be equivalent as a series circuit of a direct current voltage source $V_{DC}$, an internal resistor $R_0$ and a RC pair $R_1$, C. In contrast, the faulty battery may be equivalent as a series circuit in which an additional resistor $R_{ISC}$ is connected between two terminals of the series circuit corresponding to the normal battery. The additional resistor $R_{ISC}$ acts as a path of a leakage current $I_{ISC}$. For reference, the voltage of the direct current voltage source $V_{DC}$ is the OCV of the battery B, and the battery voltage is the total voltage of the series circuit of the direct current voltage source $V_{DC}$, the internal resistor $R_0$ and the RC pair $R_1$, C. When the voltage of the RC pair $R_1$, C is zero (0V), the relaxation voltage and the OCV are equal.

During the charging of the faulty battery, some of the charge power is not stored in the faulty battery and is consumed as the leakage current $I_{ISC}$. Additionally, during the discharging of the faulty battery, some of the discharge power is not supplied to the electrical load 30 and is consumed as the leakage current $I_{ISC}$. A reduction in resistance of the resistor $R_{ISC}$ indicates that the internal short circuit fault gets worse, and as the internal short circuit fault gets worse, the power consumption due to the leakage current $I_{ISC}$ may increase.

As a result, in the charge, the voltage change (i.e., an increase in SOC) of the faulty battery is smaller than the normal battery. In contrast, in the discharge, the voltage change (i.e., a decrease in SOC) of the faulty battery is larger than the normal battery. Furthermore, even in the no-load condition, energy stored in the faulty battery is consumed as the leakage current $I_{ISC}$.

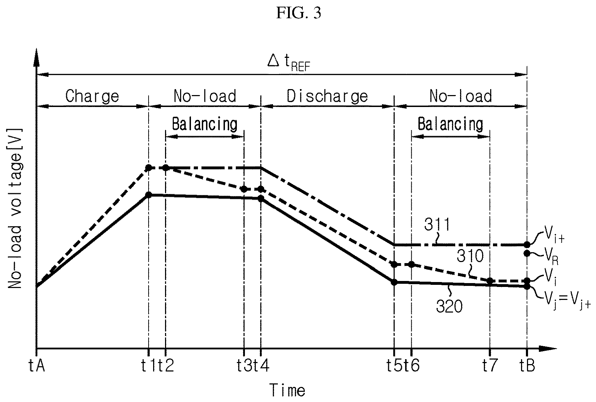

FIGS. 3 to 6 are diagrams for reference in describing the principle of internal short circuit fault detection in the battery.

FIG. 3 shows the time-dependent changes of the no-load voltage of each of the battery $B_i$ and the battery $B_j$ over the period of time during which the battery group 11 is in the load condition (charge), the no-load condition, the load condition (discharge) and the no-load condition in a sequential order. In FIG. 3, assume that the battery $B_i$ is a normal battery, and the battery $B_j$ is a faulty battery.

Referring to FIG. 3, a curve 310 shows the no-load voltage of the battery $B_i$, and a curve 320 shows the no-load voltage of the battery $B_j$. The time tB is detection timing, i.e., the time at which the control circuit 140 detects a faulty battery among the batteries $B_1$~$B_N$. The time tA is the past time that is earlier than the time tB by a referenced time $\Delta t_{REF}$. The length of the reference time $\Delta t_{REF}$ may be preset. To help an understanding, assume that the no-load voltage of the battery $B_i$ and the no-load voltage of the battery $B_j$ are equal at the time tA.

The period of time from the time tA to the time t1 is a charging period, and the no-load voltages of the battery $B_i$ and the battery $B_j$ continuously rise. However, the no-load voltage of the battery $B_j$ rises more slowly than the battery $B_i$, and the voltage difference between the battery $B_i$ and the battery $B_j$ gradually increases over the charging period tA~t1. That is, for the charging period tA~t1, the voltage imbalances between the batteries $B_1$~$B_N$ gradually get worse.

The period of time from the time t1 to the time t4 is a no-load period, and the charge/discharge of the battery $B_i$ and the battery $B_j$ is stopped. The no-load voltage of the battery $B_j$ slowly drops for the no-load period t1~t4 due to the leakage current (see FIG. 2). Meanwhile, the period from time t2 to time t3 is a period during which the balancing operation for the battery $B_L$ is performed, i.e., a balancing period of the battery $B_i$. The control circuit 140 sets the battery $B_i$ among the batteries $B_1$~$B_N$ as the target battery between the time t1 and the time t2. In an example, when the no-load voltage of the battery $B_j$ is the minimum no-load voltage of the batteries $B_1$~$B_N$ at the time t1, the no-load voltage of the battery $B_i$ is higher than the no-load voltage of the battery $B_j$, so the battery $B_i$ is set as the target battery. Among the remaining batteries, at least one battery of which the no-load voltage is lower than the minimum no-load voltage may be additionally set as the target battery. As the balancing operation for the battery $B_i$ is performed, the no-load voltage of the battery $B_i$ continuously drops over the balancing period t2~t3. That is, for the balancing period t2~t3, the voltage imbalances between the batteries $B_1$~$B_N$ are gradually mitigated.

The period of time from the time t4 to the time t5 is a discharging period, and the no-load voltages of the battery $B_i$ and the battery $B_j$ continuously drop. The no-load voltage of the battery $B_j$ drops faster than the battery $B_i$, and the voltage difference between the battery $B_i$ and the battery $B_j$ gradually increases again over the discharging period t4~t5. That is, for the discharging period t4~t5, the voltage imbalances of the batteries $B_1$~$B_N$ gradually get worse.

The period of time from the time t5 to the time tB is a no-load period. The no-load voltage of the battery $B_j$ slowly drops over the no-load period t5~tB. The period of time from the time t6 to the time t7 is a balancing period of the battery $B_i$. The control circuit 140 sets the target battery among the batteries $B_1$~$B_n$ between the time t5 and the time t6. In an example, in the same way as the time t2, at the time t6, the battery $B_i$ is set as the target battery. As the balancing operation for the battery $B_i$ is performed, the no-load voltage of the battery $B_i$ continuously drops over the balancing period t6~t7. That is, for the balancing period t6~t7, the voltage imbalances between the batteries $B_1$~$B_N$ are mitigated again.

According to the above description made with reference to FIG. 3, each time the balancing operation for the battery $B_i$ is performed, a difference in no-load voltage between the battery $B_i$ and the battery $B_j$ reduces. Accordingly, it is impossible to identify whether the battery $B_j$ is faulty or not by comparing the no-load voltage of the batteries $B_1$~$B_N$ with a certain threshold at the time tB (the internal short circuit fault detection timing).

The present invention compensates the voltage value of the no-load voltage of each battery $B_1$~$B_N$ at the detection timing (time tB) using the balancing capacity of each battery $B_1$~$B_N$ for the period (i.e., tA~tB) of the latest reference time $\Delta t_{REF}$ based on the internal short circuit fault detection timing (time tB). The compensated voltage value of the battery B indicates an estimated no-load voltage of the battery B at the detection timing (time tB) when the balancing operation for the battery B is not performed over the period of time tA~tB. Accordingly, even though the voltage imbalances between the batteries $B_1$~$B_N$ at the detection timing (time tB) are insignificant, the battery $B_j$ may be detected as faulty.

The control circuit 140 detects the faulty battery among the plurality of batteries $B_1 \sim B_N$ at each detection timing of a predetermined time interval. In an example, the reference time $\Delta t_{REF}$ may be 100 times larger than the time interval of two adjacent detection timings, and the period of time for the latest reference time $\Delta t_{REF}$ may be defined using a moving window. The control circuit 140 may detect the internal short circuit fault when the detection condition is satisfied. The detection condition is the no-load condition in which the balancing for all the plurality of batteries $B_1 \sim B_N$ is stopped.

The balancing capacity of the battery B for the period of time tA~tB is the accumulated value of the discharge capacity of the battery B by the balancing operation for the period of time tA~tB, i.e., the total discharge capacity over the period of time tA~tB. The balancing capacity of the battery (for example, $B_j$) in which the balancing operation has never been performed for the period of time tA~tB is determined to be 0Ah.

Hereinafter, the principle of determining the discharge capacity each time the balancing operation is performed once will be described.

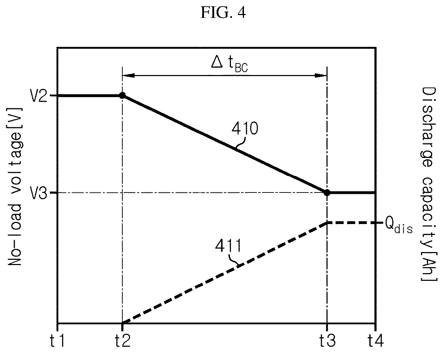

FIG. 4 illustrates the balancing operation for the battery $B_i$ within the no-load period t1~t4 in FIG. 3. A curve 410 and a curve 411 show the time-dependent changes of the no-load voltage and discharge capacity of the battery $B_i$, respectively. The voltage value of the no-load voltage of the battery $B_i$ is maintained at V2 from the time t1 to the time t2, continuously drops from the time t2 to the time t3 and reaches V3 at the time t3. The time t3 is the balancing end time of the battery $B_i$.

The control circuit 140 may determine the discharge capacity of the battery $B_i$ by the balancing operation by applying a capacity estimation function to first balancing data of the balancing operation. The first balancing data includes a start voltage value and a duration of the balancing operation. The start voltage value indicates the no-load voltage of the battery $B_i$ at the start time t2 of the balancing operation, and in FIG. 4, the start voltage value is V2. The duration indicates a length of time from the balancing start time t2 to the balancing end time t3, and in FIG. 4, the duration is $\Delta t_{BC} = t3 - t2$.

The capacity estimation function defines a correlation among the start voltage value, the duration and the discharge capacity, and may be determined through experiments performed on batteries having the same electrical and chemical performance as the battery B. The following Equation 1 is an example of the capacity estimation function.

<Equation 1>

$$Q_{dis} = \frac{V_{start}}{R} \times \Delta t_{BC}$$

In the above Equation 1, $V_{start}$ is the start voltage value, $\Delta t_{BC}$ is the duration, R is the preset resistance of the discharge resistor 131, and $Q_{dis}$ is the discharge capacity per balancing. $V_{start}/R$ indicates the balancing current flowing through the discharge resistor 131 at the start of the balancing operation.

The following Equation 2 is another example of the capacity estimation function.

<Equation 2>

$$Q_{dis} = \frac{V_{start} + V_{end}}{2R} \times \Delta t_{BC}$$

In the above Equation 2, $V_{end}$ is the end voltage value, and the remaining factors are equal to Equation 1.

Alternatively, the control circuit 140 may determine the discharge capacity of the battery $B_i$ by the balancing operation by applying the SOC-OCV map to second balancing data of the balancing operation. The second balancing data includes the start voltage value and the end voltage value of the balancing operation. The end voltage value indicates the no-load voltage at the balancing end time t3, and in FIG. 4, the end voltage value is V3. FIG. 5 shows an example of the SOC-OCV map. Referring to FIG. 5, Z2 is the SOC corresponding to the start voltage value V2, and Z3 is the SOC corresponding to the end voltage value V3. The control circuit 140 may determine the discharge capacity of the battery $B_i$ by the balancing operation for the balancing period t2~t3 by multiplying a difference between the two SOCs, i.e., Z2-Z3 by the Full Charge Capacity (FCC) of the battery $B_i$. The method for estimating the full charge capacity is well known and its detailed description is omitted.

Alternatively, the balancing capacity of the battery B may be directly calculated by finding the integral of the balancing current periodically calculated by applying the Ohm's law to the voltage and resistance of the discharge resistor 131 from the start to the end of the balancing operation.

The determination of the balancing capacity may be performed each time the balancing operation is performed once.

The balancing operation for the battery $B_i$ is performed twice for the period of time tA~tB. Accordingly, the control circuit 140 may determine the balancing capacity of the battery $B_i$ or the total capacity consumed from the battery $B_i$ for the period of time tA~tB by summing the discharge capacity for the balancing period t2~t3 and the discharge capacity for the balancing period t6~t7.

Referring to FIG. 5, the control circuit 140 may determine the estimated SOC of each battery $B_1$~$B_N$ at the detection timing (time tB). In an example, when the voltage value of the no-load voltage of the battery $B_i$ detected at the time tB is $V_i$, the control circuit 140 may determine $Z_i$ corresponding to the voltage value $V_i$ as the estimated SOC of the battery $B_i$ by applying the SOC-OCV map to the voltage value $V_i$.

The control circuit 140 may compensate the voltage value of the no-load voltage of each battery $B_1$~$B_n$ by applying a predetermined voltage compensation logic as described below to the balancing capacity of each battery $B_1$~$B_N$ for the latest reference time $\Delta t_{REF}$ on the basis of the detection timing (time tB). Specifically, the control circuit 140 may determine a SOC change amount $\Delta Z_i$ of the battery $B_i$ by dividing the balancing capacity of the battery $B_i$ by the full charge capacity of the battery $B_i$. The control circuit 140 compensates the estimated SOC of the battery $B_i$ from $Z_i$ to $Z_{i+}$ by adding the SOC change amount $\Delta Z_i$ to the estimated SOC $Z_i$. The control circuit 140 determines a voltage value $V_{i+}$ corresponding to $Z_{i+}$ by applying the SOC-OCV map to the compensated estimated SOC $Z_{i+}$. The voltage value $V_{i+}$ is the result of compensating the voltage value $V_i$ using the balancing capacity of the battery $B_i$. In contrast, since the balancing operation has never been performed on the battery $B_j$ over the period of time tA~tB, the compensated voltage value $V_{j+}$ of the battery $B_j$ is equal to the voltage value $V_j$ detected at the time tB.

Referring back to FIG. 3, a curve 311 is the result of compensating the curve 310 by applying the time-dependent change of the balancing capacity of the battery $B_i$ to the curve 310. That is, the curve 311 shows the time-dependent change of the no-load voltage of the battery $B_i$ when the balancing operation for the battery $B_i$ has never been performed over the period of time tA~tB. Since the balancing operation is not performed for the charging period tA~t1, the curve 310 and the curve 320 completely overlap for the charging period tA~t1. Additionally, since the balancing operation is not performed for the discharging period t4~t5, a difference between the curve 310 and the curve 320 is equally maintained over the discharging period t4~t5. As illustrated in FIG. 5, since the voltage value of the battery $B_i$ at the detection timing tB is compensated from $V_i$ to $V_{i+}$, it can be seen that a difference with the voltage value $V_j$ of the battery $B_j$ is expanded.

The series of processes described above (the voltage compensate logic) is commonly applied to all the batteries $B_1$~$B_N$ at each detection timing. The control circuit 140 may determine a reference voltage value to be equal to the average or median of the compensated voltage values of two or more of the batteries $B_1$~$B_N$ at each detection timing. That is, the reference voltage value may be newly updated at each detection timing. In an example, the reference voltage value may be the average or median of (i) all the compensated voltage values or (ii) a predetermined number of compensated voltage values in the descending order among the compensated voltage values, determined for the batteries $B_1$~$B_N$. Referring to FIG. 3, $V_R$ is the reference voltage value at the time tB. Alternatively, the reference voltage value may be a given value irrespective of the voltage change of the batteries $B_1$~$B_N$.

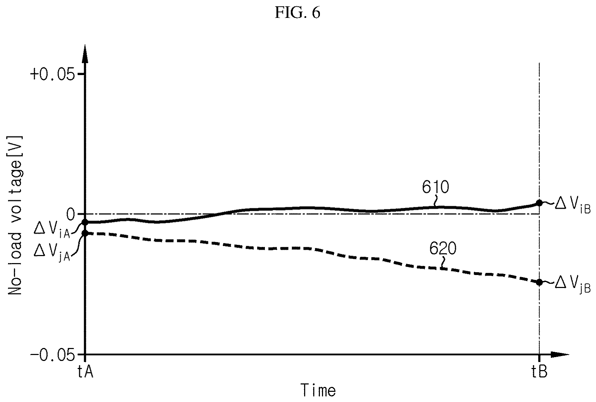

The control circuit 140 may determine a voltage deviation which is a difference between the reference voltage value and the compensated voltage value of the battery B at each detection timing. Additionally, the control circuit 140 may record, in the memory 141, a time-series indicating the time-dependent changes of the voltage deviation of the battery B determined multiple times in a sequential order over the period of time tA~tB for the latest reference time $\Delta t_{REF}$. When the voltage deviation of the battery B at some detection timings within the period of time tA~tB is omitted, the omitted voltage deviation values may be added to the time-series by applying interpolation to the remaining voltage deviation values within the time-series. In FIG. 6, a curve 610 and a curve 620 show the time-dependent changes of the voltage deviation of the battery $B_i$ and the voltage deviation of the battery $B_j$, respectively.

The control circuit 140 determines a change amount of the voltage deviation of the battery B during the latest reference time $\Delta t_{REF}$. In FIG. 6, $\Delta V_{iA}$ and $\Delta V_{iB}$ are the voltage deviation of the battery $B_i$ at time tA and tB, respectively, and the change amount of the voltage deviation of the battery $B_i$ is $\Delta V_{iA} - \Delta V_{iB}$. Additionally, $\Delta V_{jA}$ and $\Delta V_{jB}$ are the voltage deviation of the battery $B_j$ at time tA and tB, respectively, and the change amount of the voltage deviation of the battery $B_j$ is $\Delta V_{jA} - \Delta V_{jB}$. For reference, referring to FIG. 3, $\Delta V_{iB} = V_{i+} - V_R$, and $\Delta V_{jB} = V_{j+} - V_R$.

The control circuit 140 determines whether the battery B is in the internal short circuit fault or not by comparing the change amount of the voltage deviation of the battery B with the threshold at each detection timing. In an example, in case that $(\Delta V_{iA} - \Delta V_{iB}) <$ the threshold $\leq (\Delta V_{jA} - \Delta V_{jB})$ at the time tB, the battery $B_i$ is determined to be normal, and the battery $B_j$ is determined to be faulty.

The control circuit 140 may count the number of times the change amount of the voltage deviation of the battery B is equal to or larger than the threshold in succession by comparing the change amount of the voltage deviation of the battery B with the threshold at each detection timing, and determine that the battery B is in the internal short circuit fault when the counted number of times reaches a predetermined number of times.

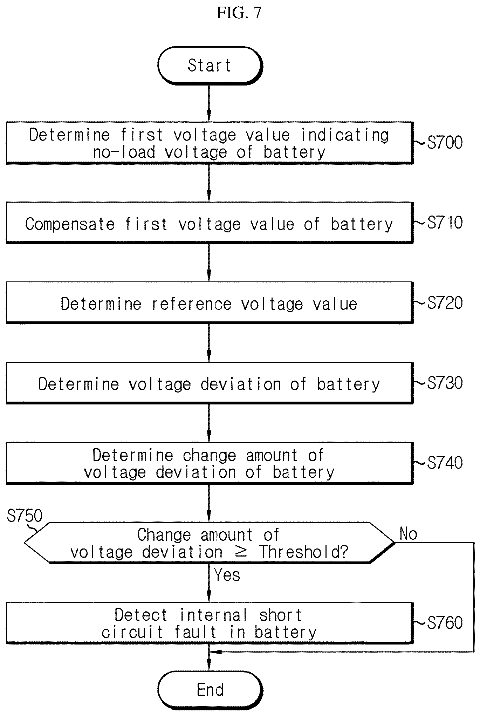

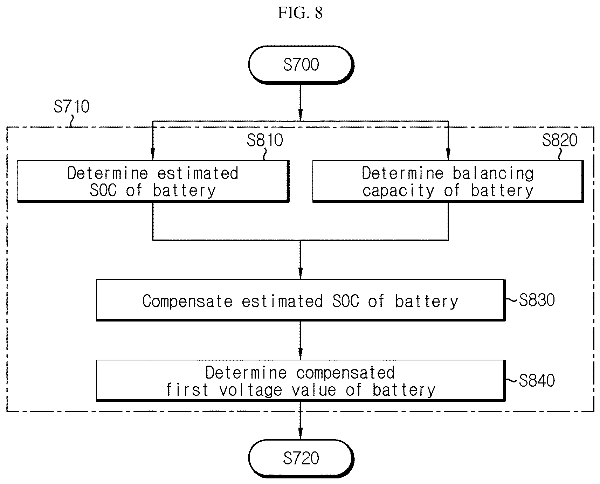

FIGS. 7 and 8 are flowcharts exemplarily showing a battery management method according to a first embodiment of the present disclosure. The method of FIG. 7 may be repeatedly performed at a predetermined time interval. To help an understanding, the following description will be made under the assumption that the method of FIG. 7 is performed at the time tB.

Referring to FIGS. 1 to 7, in step S700, the control circuit 140 determines a first voltage value indicating the no-load voltage of the battery B. For example, $V_i$ and $V_j$ of FIG. 3 indicate the first voltage value of the battery $B_i$ and the first voltage value of the battery $B_j$, respectively.

In step S710, the control circuit 140 compensates the first voltage value of the battery B using the balancing capacity of the battery B. The step S710 may include subroutines S810, S820, S830 and S840 shown in FIG. 8.

In step S810, the control circuit 140 determines the estimated SOC of the battery B by applying the SOC-OCV map to the first voltage value of the battery B. Referring to FIG. 5, $Z_i$ is the estimated SOC of the battery $B_i$ corresponding to the first voltage value $V_i$ of the battery $B_i$.

In step S820, the control circuit 140 determines the balancing capacity of the battery B. The balancing capacity of the battery B may be the accumulated value of the discharge capacity by the balancing operation performed on the battery B for the latest reference time $\Delta t_{REF}$.

In step S830, the control circuit 140 compensates the estimated SOC of the battery B by adding the SOC change amount corresponding to the balancing capacity to the estimated SOC of the battery B. Referring to FIG. 5, the compensated estimated SOC $Z_{i+}$ of the battery $B_i$ is acquired by adding $\Delta Z_i$ to $Z_i$.

In step S840, the control circuit 140 determines the compensated first voltage value of the battery B by applying the SOC-OCV map to the compensated estimated SOC of the battery B. Referring to FIG. 5, the compensated first voltage value of the battery B is determined to be equal to $V_{i+}$ corresponding to $Z_{i+}$.

In step S720, the control circuit 140 determines the reference voltage value. $V_R$ in FIG. 3 is the reference voltage value at the time tB.

In step S730, the control circuit 140 determines the voltage deviation of the battery B to be equal to a difference between the compensated first voltage value of the battery B and the reference voltage value. Referring to FIG. 6, $\Delta V_{iB}$ and $\Delta V_{jB}$ are the voltage deviation of the battery $B_i$ and the voltage deviation of the battery $B_j$, respectively.

In step S740, the control circuit 140 determines the change amount of the voltage deviation of the battery B for the latest reference time $\Delta t_{REF}$. Referring to FIG. 6, $(\Delta V_{iA} - \Delta V_{iB})$ is the change amount of the voltage deviation of the battery $B_i$, and $(\Delta V_{jA} - \Delta V_{jB})$ is the change amount of the voltage deviation of the battery $B_j$.

In step S750, the control circuit 140 determines whether the change amount of the voltage deviation of the battery B is equal to or larger than the threshold. When a value of the step S750 is "Yes", step S760 is performed.

In the step S760, the control circuit 140 detects the internal short circuit fault in the battery B. Additionally, the control circuit 140 may perform a predetermined protection operation. The protection operation may include outputting a diagnosis message notifying that the battery B is in the internal short circuit fault. The diagnosis message may be transmitted to the vehicle controller 2 through the communication circuit 150. The communication circuit 150 may output a warning signal to the user upon receiving the diagnosis message.

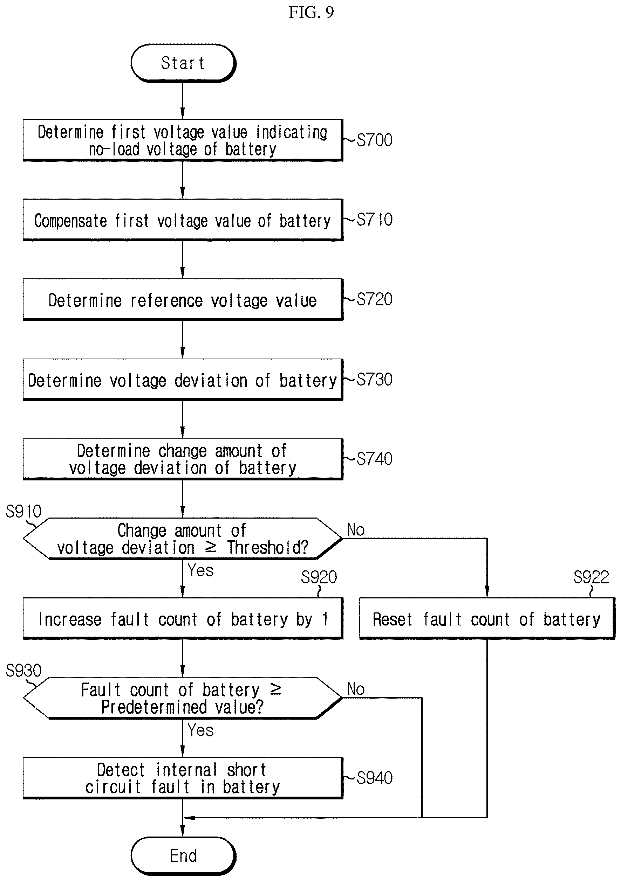

FIG. 9 is a flowchart exemplarily showing a battery management method according to a second embodiment of the present disclosure. The method of FIG. 9 may be repeatedly performed at a predetermined time interval. To help an understanding, the following description will be made under the assumption that the method of FIG. 9 is performed at the time tB.

Referring to FIG. 9, the process from the step S700 to the step S740 is the same as the first embodiment. After the step S740 is performed, step S910 is performed. In the step S910, the control circuit 140 determines whether the change amount of the voltage deviation of the battery B is equal to or larger than the threshold. When a value of the step S910 is "Yes", step S920 is performed. When the value of the step S910 is "No", step S922 is performed.

In the step S920, the control circuit 140 increases a fault count of the battery B by 1. In the step S922, the control circuit 140 resets the fault count of the battery B to be equal to an initial value (for example, 0).

In step S930, the control circuit 140 determines whether the fault count of the battery B is equal to or larger than a predetermined value. That is, the control circuit 140 determines if the number of times the change amount of the voltage deviation of the battery B is equal to or larger than the threshold is counted in succession the predetermined of times. When a value of the step S930 is "Yes", step S940 is performed.

In the step S940, the control circuit 140 detects the internal short circuit fault in the battery B. In the same way as the first embodiment, the control circuit 140 may perform a predetermined protection operation.

The second embodiment as a variation of the first embodiment may prevent the incorrect fault detection.

(Description of Reference Numerals)

1: Electric vehicle
10: Battery pack B: Battery
100: Battery management system
110: Battery monitor
130: Balancer
140: Control circuit

**Claims**

1.  A battery management system (100), comprising:

    a battery monitor (110) configured to detect a voltage of each of a plurality of batteries ($B_1..B_N$) connected in series;
    a balancer (130) configured to perform a balancing operation for each battery ($B_j$); and
    a control circuit (140) configured to control the balancer (130) based on the voltage of each battery detected by the battery monitor (110),
    wherein, at each detection timing of a predetermined time interval while the balancer (130) is stopped during a period of no-load applied to the plurality of batteries ($B_1..B_N$), the control circuit (140) is configured to:

    determine a first voltage value ($V_j$) indicating a no-load voltage of each battery ($B_j$) at a first time (tB) corresponding to the detection timing,
    compensate the first voltage value ($V_j$) of each battery ($B_j$) using a balancing capacity, wherein the balancing capacity is a total capacity consumed from the corresponding battery ($B_j$) by the balancing operation during a period from a second time (tA) to the first time (tB), and the second time (tA) is an earlier time than the first time (tB) by a preset reference time ($\Delta t_{REF}$),
    determine a first voltage deviation ($\Delta V_{jB}$) which is a difference between the compensated first voltage value ($V_{j+}$) of each battery ($B_j$) and a reference voltage value ($V_R$), and
    detect an internal short circuit fault in each battery ($B_j$) by comparing a change amount of the voltage deviation of each battery ($B_j$) with a threshold,
    wherein the change amount of the voltage deviation is defined as a difference between the first voltage deviation ($\Delta V_{jB}$) and a second voltage deviation ($\Delta V_{jA}$), and the second voltage deviation ($\Delta V_{jA}$) indicates a previously determined voltage deviation at the second time (tA).

2.  The battery management system (100) according to claim 1, wherein the control circuit (140) is configured to:

    increase a fault count of corresponding battery by 1 when the change amount of the voltage deviation of each battery is equal to or larger than the threshold,
    detect the internal short circuit fault in corresponding battery when the fault count of each battery is equal to or larger than a predetermined value.

3.  The battery management system (100) according to claim 1, wherein the control circuit (140) is configured to determine the reference voltage value to be equal to an average or median of the compensated first voltage values of at least two of the plurality of batteries.

4.  The battery management system (100) according to claim 1, wherein the balancer (130) includes a plurality of balancing circuits ($D1..D_N$) connected in parallel to the plurality of batteries ($B1..B_N$) in a one-to-one correspondence relationship, and
    wherein each balancing circuit includes a discharge resistor and a discharge switch connected in series.

5.  The battery management system (100) according to claim 1, wherein the control circuit (140) is configured to determine the balancing capacity of each battery by accumulating the discharge capacity of each battery by each balancing operation within a period of the preset reference time ($\Delta t_{REF}$).

**6.** The battery management system (100) according to claim 5, wherein the control circuit (140) is configured to determine the discharge capacity of each battery by each balancing operation by applying a capacity estimation function to first balancing data associated with each balancing operation, and

wherein the first balancing data includes a second voltage value indicating the no-load voltage of each battery at a start of the balancing operation and a duration of the balancing operation.

**7.** The battery management system (100) according to claim 5, wherein the control circuit (140) is configured to determine the discharge capacity of each battery by each balancing operation by applying a state of charge, SOC,-open circuit voltage, OCV, map to second balancing data of each balancing operation, and

wherein the second balancing data includes a second voltage value indicating the no-load voltage of each battery at a start of the balancing operation and a third voltage value indicating the no-load voltage of each battery at an end of the balancing operation.

**8.** The battery management system (100) according to claim 1, wherein the control circuit (140) is configured to:

determine an estimated SOC of each battery by applying a SOC-OCV map to the first voltage value of each battery,
compensate the estimated SOC of each battery by adding a SOC change amount corresponding to the balancing capacity to the estimated SOC of each battery, and
determine the compensated first voltage value by applying the SOC-OCV map to the compensated estimated SOC of each battery.

**9.** A battery pack (10) comprising the plurality of batteries connected in series (11), a relay (20) and the battery management system (100) according to any one of claims 1 to 8.

**10.** An electric vehicle (1) comprising the battery pack (10) according to claim 9.

**11.** A battery management method, comprising:

performing a balancing operation for each battery in a plurality of batteries ($B1..B_N$) connected in series; and
at each detection timing of a predetermined time interval while the balancing operation is stopped during a period of no-load applied to the plurality of batteries ($B1..B_N$), the battery management method further comprising:

determining (S700) a first voltage value ($V_j$) indicating a no-load voltage of each battery ($B_j$) of the plurality of batteries ($B1..B_n$) at a first time (tB) corresponding to the detection timing;
compensating (S710) the first voltage value ($V_j$) of each battery ($B_j$) using a balancing capacity, wherein the balancing capacity is a total capacity consumed from the corresponding battery by the balancing operation during a period from a second time (tA) to the first time (tB), and the second time (tA) is an earlier time than the first time (tB) by a preset reference time ($\Delta t_{REF}$);
determining (S730) a first voltage deviation ($\Delta V_{jB}$) which is a difference between the compensated first voltage value ($V_{j+}$) of each battery ($B_j$) and a reference voltage value ($V_R$); and
detecting (S760) an internal short circuit fault in each battery ($B_j$) by comparing a change amount of the voltage deviation of each battery ($B_j$) with a threshold,
wherein the change amount of the voltage deviation is defined as a difference between the first voltage deviation ($\Delta V_{jB}$) and a second voltage deviation ($\Delta V_{jA}$), and the second voltage deviation ($\Delta V_{jA}$) indicates a previously determined voltage deviation at the second time wherein the reference time ($\Delta tREF$) is set longer than the predetermined detection interval.

**12.** The battery management method according to claim 11, wherein detecting (S760) the internal short circuit fault in each battery comprises:

increasing (S920) a fault count of each battery by 1 when the change amount of the voltage deviation of each battery is equal to or larger than the threshold; and
detecting (S940) the internal short circuit fault in each battery when the fault count of each battery is equal to or larger than a predetermined value.

**13.** The battery management method according to claim 11, further comprising:
determining (S720) the reference voltage value to be equal to an average or median of the compensated first voltage values of at least two of the plurality of batteries.

14. The battery management method according to claim 11, wherein compensating (S710) the first voltage value of each battery comprises:

determining an estimated state of charge, SOC, of each battery by applying a SOC-open circuit voltage, OCV, map to the first voltage value of each battery;
compensating the estimated SOC of each battery by adding a SOC change amount corresponding to the balancing capacity to the estimated SOC of each battery; and
determining the compensated first voltage value by applying the SOC-OCV map to the compensated estimated SOC of each battery.

**Patentansprüche**

1. Batterieverwaltungssystem (100), umfassend:

eine Batterieüberwachungseinheit (110), welche dazu eingerichtet ist, eine Spannung jeder aus einer Mehrzahl von Batterien ($B_1..B_N$), welche in Serie geschaltet sind, zu detektieren;
eine Ausgleichseinheit (130), welche dazu eingerichtet ist, einen Ausgleichsvorgang für jede Batterie ($B_j$) durchzuführen; und
eine Steuerungsschaltung (140), welche dazu eingerichtet ist, die Ausgleichseinheit (130) auf Grundlage der Spannung jeder Batterie, welche durch die Batterieüberwachungseinheit (110) detektiert wird, zu steuern,
wobei die Steuerungsschaltung (140), zu jedem Detektionszeitpunkt eines vorbestimmten Zeitintervalls, während die Ausgleichseinheit (130) gestoppt ist, während einer Periode, in welcher keine Last an der Mehrzahl von Batterien ($B_1..B_N$) anliegt, eingerichtet ist zum:

Bestimmen eines ersten Spannungswerts ($V_j$), welcher eine Keine-Last-Spannung jeder Batterie ($B_j$) zu einer ersten Zeit (tB) angibt, welche dem Detektionszeitpunkt entspricht,
Kompensieren des ersten Spannungswerts ($V_j$) jeder Batterie ($B_j$) unter Verwendung einer Ausgleichskapazität, wobei die Ausgleichskapazität eine gesamte Kapazität ist, welche von der jeweiligen Batterie ($B_j$) durch den Ausgleichsvorgang während einer Periode von einer zweiten Zeit (tA) zu der ersten Zeit (tB) aufgebraucht wird, und wobei die zweite Zeit (tA) eine um eine vorfestgelegte Referenzzeit ($\Delta t_{REF}$) frühere Zeit ist als die erste Zeit (tB),
Bestimmen einer ersten Spannungsabweichung ($\Delta V_{jB}$), welche eine Differenz zwischen dem kompensierten ersten Spannungswert ($V_{j+}$) jeder Batterie ($B_j$) und einem Referenzspannungswert ($V_R$) ist, und Detektieren eines internen Kurzschlussfehlers in jeder Batterie ($B_j$) durch Vergleichen eines Änderungsbetrags der Spannungsabweichung jeder Batterie ($B_j$) mit einem Schwellenwert,
wobei der Änderungsbetrag der Spannungsabweichung als eine Differenz zwischen der ersten Spannungsabweichung ($\Delta V_{jB}$) und einer zweiten Spannungsabweichung ($\Delta V_{jA}$) definiert ist, und wobei die zweite Spannungsabweichung ($\Delta V_{jA}$) eine vorher bestimmte Spannungsabweichung zu der zweiten Zeit (tA) angibt.

2. Batterieverwaltungssystem (100) nach Anspruch 1, wobei die Steuerungsschaltung (40) eingerichtet ist zum:

Erhöhen einer Fehlerzahl einer jeweiligen Batterie um 1, wenn der Änderungsbetrag der Spannungsabweichung jeder Batterie gleich wie oder größer als der Schwellenwert ist,
Detektieren des internen Kurzschlussfehlers in einer jeweiligen Batterie, wenn die Fehlerzahl jeder Batterie gleich wie oder größer als ein vorbestimmter Wert ist.

3. Batterieverwaltungssystem (100) nach Anspruch 1, wobei die Steuerungsschaltung (140) dazu eingerichtet ist, den Referenzspannungswert zu bestimmen, um gleich einem Durchschnitt oder einem Median der kompensierten ersten Spannungswerte von wenigstens zwei aus der Mehrzahl von Batterien zu sein.

4. Batterieverwaltungssystem (100) nach Anspruch 1, wobei die Ausgleichseinheit (130) eine Mehrzahl von Ausgleichsschaltungen ($D1..D_N$) umfasst, welche zu der Mehrzahl von Batterien ($B1..B_N$) in einer eins-zu-eins Bezugsbeziehung parallel geschaltet sind, und
wobei jede Ausgleichsschaltung einen Entladewiderstand und einen Entladeschalter umfasst, welche in Serie geschaltet sind.

5. Batterieverwaltungssystem (100) nach Anspruch 1, wobei die Steuerungsschaltung (140) dazu eingerichtet ist, die Ausgleichskapazität jeder Batterie durch Akkumulieren der Entladekapazität jeder Batterie durch jeden Ausgleichvorgang in einer Periode der vorfestgelegten Referenzzeit ($\Delta t_{REF}$) zu bestimmen.

6. Batterieverwaltungssystem (100) nach Anspruch 5, wobei die Steuerungsschaltung (140) dazu eingerichtet ist, die Entladekapazität jeder Batterie durch jeden Ausgleichsvorgang durch Anwenden einer Kapazitätschätzungsfunktion auf erste Ausgleichsdaten, welche im Zusammenhang mit jedem Ausgleichsvorgang stehen, zu bestimmen, und wobei die ersten Ausgleichsdaten einen zweiten Spannungswert umfassen, welcher die Keine-Last-Spannung jeder Batterie bei einem Start des Ausgleichsvorgangs und einer Dauer des Ausgleichsvorgangs angibt.

7. Batterieverwaltungssystem (100) nach Anspruch 5, wobei die Steuerungsschaltung (140) dazu eingerichtet ist, die Entladekapazität jeder Batterie durch jeden Ausgleichsvorgang durch Anwenden einer Ladezustand-, SOC-, Leelaufspannung-, OCV-, Karte auf zweite Ausgleichsdaten jedes Ausgleichsvorgangs zu bestimmen, und wobei die zweiten Ausgleichsdaten einen zweiten Spannungswert, welcher die Keine-Last-Spannung jeder Batterie bei einem Start des Ausgleichsvorgangs angibt, und einen dritten Spannungswert umfassen, welcher eine Keine-Last-Spannung jeder Batterie bei einem Ende des Ausgleichsvorgangs angibt.

8. Batterieverwaltungssystem (100) nach Anspruch 1, wobei die Steuerungsschaltung (140) eingerichtet ist zum:

   Bestimmen eines geschätzten SOC jeder Batterie durch Anwenden einer SOC-OCV-Karte auf den ersten Spannungswert jeder Batterie,
   Kompensieren des geschätzten SOC jeder Batterie durch Addieren eines SOC-Änderungsbetrags, welcher der Ausgleichskapazität entspricht, zu dem geschätzten SOC jeder Batterie, und
   Bestimmen des kompensierten ersten Spannungswerts durch Anwenden der SOC-OCV-Karte auf den kompensierten geschätzten SOC jeder Batterie.

9. Batteriepack (10), umfassend die Mehrzahl von Batterien (11), welche in Serie geschaltet sind, ein Relais (20) und das Batterieverwaltungssystem (100) nach einem der Ansprüche 1 bis 8.

10. Elektrisches Fahrzeug (1), umfassend den Batteriepack (10) nach Anspruch 9.

11. Batterieverwaltungsverfahren, umfassend:

   Durchführen eines Ausgleichsvorgangs für jede Batterie in einer Mehrzahl von Batterien ($B_1..B_N$), welche in Serie geschaltet sind; und
   wobei zu jedem Detektionszeitpunkt eines vorbestimmten Zeitintervalls, während der Ausgleichsvorgang gestoppt ist, während einer Periode, in welcher keine Last an der Mehrzahl von Batterien ($B1..B_N$) anliegt, das Batterieverwaltungsverfahren ferner umfasst:

      Bestimmen (S700) eines ersten Spannungswerts ($V_j$), welcher eine Keine-Last-Spannung jeder Batterie ($B_j$) aus der Mehrzahl von Batterien ($B_1..B_N$), zu einer ersten Zeit (tB) angibt, welche dem Detektionszeitpunkt entspricht,
      Kompensieren (S710) des ersten Spannungswerts ($V_j$) jeder Batterie ($B_j$) unter Verwendung einer Ausgleichskapazität, wobei die Ausgleichskapazität eine gesamte Kapazität ist, welche von der jeweiligen Batterie ($B_j$) durch den Ausgleichsvorgang während einer Periode von einer zweiten Zeit (tA) zu der ersten Zeit (tB) aufgebraucht wird, und wobei die zweite Zeit (tA) eine um eine vorfestgelegte Referenzzeit ($\Delta t_{REF}$) frühere Zeit ist als die erste Zeit (tB),
      Bestimmen (S730) einer ersten Spannungsabweichung ($\Delta V_{jB}$), welche eine Differenz zwischen dem kompensierten ersten Spannungswert ($V_{j+}$) jeder Batterie ($B_j$) und einem Referenzspannungswert ($V_R$) ist, und
      Detektieren (S760) eines internen Kurzschlussfehlers in jeder Batterie ($B_j$) durch Vergleichen eines Änderungsbetrags der Spannungsabweichung jeder Batterie ($B_j$) mit einem Schwellenwert,
      wobei der Änderungsbetrag der Spannungsabweichung als eine Differenz zwischen der ersten Spannungsabweichung ($\Delta V_{jB}$) und einer zweiten Spannungsabweichung ($\Delta V_{jA}$) definiert ist, und wobei die zweite Spannungsabweichung ($\Delta V_{jA}$) eine vorher bestimmte Spannungsabweichung zu der zweiten Zeit angibt, wobei die Referenzzeit ($\Delta t_{REF}$) länger als das vorbestimmte Detektionsintervall festgelegt wird.

**12.** Batterieverwaltungsverfahren nach Anspruch 11, wobei das Detektieren (760) des internen Kurzschlussfehlers in jeder Batterie umfasst:

Erhöhen (S920) einer Fehlerzahl jeder Batterie um 1, wenn der Änderungsbetrag der Spannungsabweichung jeder Batterie gleich wie oder größer als der Schwellenwert ist; und
Detektieren (S940) des internen Kurzschlussfehlers in jeder Batterie, wenn die Fehlerzahl jeder Batterie gleich wie oder größer als ein vorbestimmter Wert ist.

**13.** Batterieverwaltungsverfahren nach Anspruch 11, ferner umfassend:
Bestimmen (S720) des Referenzspannungswerts, um gleich einem Durchschnitt oder einem Median der kompensierten ersten Spannungswerte von wenigstens zwei aus der Mehrzahl von Batterien zu sein.

**14.** Batterieverwaltungsverfahren nach Anspruch 11, wobei das Kompensieren (S710) des ersten Spannungswerts jeder Batterie umfasst:

Bestimmen eines geschätzten Ladezustands, SOC, jeder Batterie durch Anwenden einer SOC-Leerlaufspannung-, OCV-, Karte auf den ersten Spannungswert jeder Batterie;
Kompensieren des geschätzten SOC jeder Batterie durch Addieren eines SOC-Änderungsbetrags, welcher der Ausgleichskapazität entspricht, zu dem geschätzten SOC jeder Batterie; und
Bestimmen des kompensierten ersten Spannungswerts durch Anwenden der SOC-OCV-Karte auf den kompensierten geschätzten SOC jeder Batterie.

## Revendications

**1.** Appareil de gestion de batteries (100), comprenant :

un moniteur de batteries (110) configuré pour détecter une tension de chacune d'une pluralité de batteries ($B_1..B_N$) connectées en série ;
un équilibreur (130) configuré pour effectuer une opération d'équilibrage pour chaque batterie ($B_j$) ; et
un circuit de commande (140) configuré pour commander l'équilibreur (130) sur la base de la tension de chaque batterie détectée par le moniteur de batteries (110),
dans lequel, à chaque instant de détection d'un intervalle de temps prédéterminé pendant que l'équilibreur (130) est arrêté pendant une période où aucune charge n'est appliquée à la pluralité de batteries ($B_1..B_N$), le circuit de commande (140) est configuré pour :

déterminer une première valeur de tension ($V_j$) indiquant une tension à vide de chaque batterie ($B_j$) à une premier temps ($tB$) correspondant à l'instant de détection,
compenser la première valeur de tension ($V_j$) de chaque batterie ($B_j$) à l'aide d'une capacité d'équilibrage,
dans lequel la capacité d'équilibrage est une capacité totale consommée par la batterie ($B_j$) correspondante par l'opération d'équilibrage pendant une période allant d'un second temps ($tA$) au premier temps ($tB$), et le second temps ($tA$) est un temps antérieur au premier temps ($tB$) d'un temps de référence prédéfini ($\Delta t_{REF}$),
déterminer un premier écart de tension ($\Delta V_{jB}$) qui est une différence entre la première valeur de tension compensée ($V_{j+}$) de chaque batterie ($B_j$) et une valeur de tension de référence ($V_R$), et
détecter un défaut de court-circuit interne dans chaque batterie ($B_j$) en comparant une quantité de changement de l'écart de tension de chaque batterie ($B_j$) à un seuil,
dans lequel la quantité de changement de l'écart de tension est définie comme une différence entre le premier écart de tension ($\Delta V_{jB}$) et un second écart de tension ($\Delta V_{jA}$), et le second écart de tension ($\Delta V_{jA}$) indique un écart de tension déterminé précédemment au second temps ($tA$).

**2.** Système de gestion de batteries (100) selon la revendication 1, dans lequel le circuit de commande (140) est configuré pour :

augmenter un décompte de défauts de batterie correspondante de 1 lorsque la quantité de changement de l'écart de tension de chaque batterie est égale ou supérieure au seuil,
détecter le défaut de court-circuit interne dans la batterie correspondante lorsque le décompte de défauts de chaque batterie est égal ou supérieur à une valeur prédéterminée.

3. Système de gestion de batteries (100) selon la revendication 1, dans lequel le circuit de commande (140) est configuré pour déterminer la valeur de tension de référence pour qu'elle soit égale à une moyenne ou une médiane des premières valeurs de tension compensées d'au moins deux de la pluralité de batteries.

4. Système de gestion de batteries (100) selon la revendication 1, dans lequel l'équilibreur (130) comporte une pluralité de circuits d'équilibrage (D1..D$_N$) connectés en parallèle à la pluralité de batteries (B1..B$_N$) selon une relation de correspondance biunivoque, et
dans lequel chaque circuit d'équilibrage comporte une résistance de décharge et un commutateur de décharge connectés en série.

5. Système de gestion de batteries (100) selon la revendication 1, dans lequel le circuit de commande (140) est configuré pour déterminer la capacité d'équilibrage de chaque batterie en accumulant la capacité de décharge de chaque batterie par chaque opération d'équilibrage dans une période du temps de référence prédéfini ($\Delta t_{REF}$).

6. Système de gestion de batteries (100) selon la revendication 5, dans lequel le circuit de commande (140) est configuré pour déterminer la capacité de décharge de chaque batterie par chaque opération d'équilibrage en appliquant une fonction d'estimation de capacité à des premières données d'équilibrage associées à chaque opération d'équilibrage, et
dans lequel les premières données d'équilibrage comportent une deuxième valeur de tension indiquant la tension à vide de chaque batterie à un début de l'opération d'équilibrage et une durée de l'opération d'équilibrage.

7. Système de gestion de batteries (100) selon la revendication 5, dans lequel le circuit de commande (140) est configuré pour déterminer la capacité de décharge de chaque batterie par chaque opération d'équilibrage en appliquant une carte d'état de charge, SOC, -tension en circuit ouvert, OCV, à des secondes données d'équilibrage de chaque opération d'équilibrage, et
dans lequel les secondes données d'équilibrage comportent une deuxième valeur de tension indiquant la tension à vide de chaque batterie à un début de l'opération d'équilibrage et une troisième valeur de tension indiquant la tension à vide de chaque batterie à une fin de l'opération d'équilibrage.

8. Système de gestion de batteries (100) selon la revendication 1, dans lequel le circuit de commande (140) est configuré pour :

déterminer un SOC estimé de chaque batterie en appliquant une carte SOC-OCV à la première valeur de tension de chaque batterie,
compenser le SOC estimé de chaque batterie en ajoutant une quantité de changement SOC correspondant à la capacité d'équilibrage du SOC estimé de chaque batterie, et
déterminer la première valeur de tension compensée en appliquant la carte SOC-OCV au SOC estimé compensé de chaque batterie.

9. Bloc-batterie (10) comprenant la pluralité de batteries connectées en série (11), un relais (20) et le système de gestion de batteries (100) selon l'une quelconque des revendications 1 à 8.

10. Véhicule électrique (1) comprenant le bloc-batterie (10) selon la revendication 9.

11. Procédé de gestion de batteries, comprenant :

la réalisation d'une opération d'équilibrage pour chaque batterie d'une pluralité de batteries (B1..B$_N$) connectées en série ; et
à chaque instant de détection d'un intervalle de temps prédéterminé pendant que l'opération d'équilibrage est arrêté pendant une période où aucune charge n'est appliquée à la pluralité de batteries (B1..B$_N$), le procédé de gestion de batteries comprenant en outre :

la détermination (S700) d'une première valeur de tension (V$_j$) indiquant une tension à vide de chaque batterie (B$_j$) de la pluralité de batteries (B1..B$_N$) à un premier temps (tB) correspondant à l'instant de détection ;
la compensation (S710) de la première valeur de tension (V$_j$) de chaque batterie (B$_j$) à l'aide d'une capacité d'équilibrage, dans lequel la capacité d'équilibrage est une capacité totale consommée par la batterie correspondante par l'opération d'équilibrage pendant une période allant d'un second temps (tA) au premier temps (tB), et le second temps (tA) est un temps antérieur au premier temps (tB) d'un temps de référence

prédéfini ($\Delta t_{REF}$),

la détermination (S730) d'un premier écart de tension ($\Delta V_{jB}$) qui est une différence entre la première valeur de tension compensée ($V_{j+}$) de chaque batterie ($B_j$) et une valeur de tension de référence ($V_R$) ; et

la détection (S760) d'un défaut de court-circuit interne dans chaque batterie ($B_j$) en comparant une quantité de changement de l'écart de tension de chaque batterie ($B_j$) à un seuil,

dans lequel la quantité de changement de l'écart de tension est définie comme une différence entre le premier écart de tension ($\Delta V_{jB}$) et un second écart de tension ($\Delta V_{jA}$), et le second écart de tension ($\Delta V_{jA}$) indique un écart de tension précédemment déterminé au second temps dans lequel le temps de référence ($\Delta t_{REF}$) est établi à un temps plus long que l'intervalle de détection prédéterminé.

12. Procédé de gestion de batteries selon la revendication 11, dans lequel la détection (S760) du défaut de court-circuit interne dans chaque batterie comprend :

l'augmentation (S920) d'un décompte de défauts de chaque batterie de 1 lorsque la quantité de changement de l'écart de tension de chaque batterie est égale ou supérieure au seuil ; et

la détection (S940) du défaut de court-circuit interne dans chaque batterie lorsque le décompte de défauts de chaque batterie est égal ou supérieur à une valeur prédéterminée.

13. Procédé de gestion de batteries selon la revendication 11, comprenant en outre :

la détermination (S720) de la valeur de tension de référence pour qu'elle soit égale à une moyenne ou une médiane des premières valeurs de tension compensées d'au moins deux de la pluralité de batteries.

14. Procédé de gestion de batteries selon la revendication 11, dans lequel la compensation (S710) de la première valeur de tension de chaque batterie comprend :

la détermination d'un état de charge, SOC, estimé de chaque batterie en appliquant une carte SOC-tension en circuit ouvert, OCV, à la première valeur de tension de chaque batterie ;

la compensation du SOC estimé de chaque batterie en ajoutant une quantité de changement SOC correspondant à la capacité d'équilibrage au SOC estimé de chaque batterie ; et

la détermination de la première valeur de tension compensée en appliquant la carte SOC-OCV au SOC estimé compensé de chaque batterie.

FIG. 1

FIG. 2

FIG. 3

FIG. 4

FIG. 5

FIG. 6

FIG. 7

```
                    ┌─────────────┐
                    │    Start    │
                    └─────────────┘
                           │
   ┌───────────────────────────────────────────────┐
   │  Determine first voltage value indicating      │~S700
   │         no-load voltage of battery             │
   └───────────────────────────────────────────────┘
                           │
   ┌───────────────────────────────────────────────┐
   │   Compensate first voltage value of battery    │~S710
   └───────────────────────────────────────────────┘
                           │
   ┌───────────────────────────────────────────────┐
   │       Determine reference voltage value        │~S720
   └───────────────────────────────────────────────┘
                           │
   ┌───────────────────────────────────────────────┐
   │    Determine voltage deviation of battery      │~S730
   └───────────────────────────────────────────────┘
                           │
   ┌───────────────────────────────────────────────┐
   │         Determine change amount of             │~S740
   │        voltage deviation of battery            │
   └───────────────────────────────────────────────┘
                           │
 S750  ◇────────────────────────────────────────◇  No
       ◇         Change amount of                ◇────┐
       ◇   voltage deviation ≥ Threshold?        ◇    │
       ◇────────────────────────────────────────◇    │
                        │ Yes                         │
   ┌───────────────────────────────────────────────┐ │
   │           Detect internal short                │~S760
   │         circuit fault in battery               │ │
   └───────────────────────────────────────────────┘ │
                           │◄────────────────────────┘
                    ┌─────────────┐
                    │     End     │
                    └─────────────┘
```

FIG. 8

```
                    ┌──────────┐
                    │   S700   │
                    └────┬─────┘
                         │
                         ▼
S710 ┌ ─ ─ ─ ─ ─ ─ ─ ─ ─ ─ ─ ─ ─ ─ ─ ─ ─ ─ ─ ─ ─ ─ ─ ─ ─ ─ ─ ┐
     │             ┌─────────────┴─────────────┐              │
     │   S810      │                            │    S820      │
     │   ┌─────────▼──────────┐    ┌────────────▼───────────┐  │
     │   │ Determine estimated│    │   Determine balancing  │  │
     │   │   SOC of battery   │    │   capacity of battery  │  │
     │   └─────────┬──────────┘    └────────────┬───────────┘  │
     │             └──────────────┬─────────────┘              │
     │                            ▼                            │
     │   ┌────────────────────────────────────────────┐       │
     │   │     Compensate estimated SOC of battery     │~S830  │
     │   └────────────────────┬───────────────────────┘       │
     │                        ▼                               │
     │   ┌────────────────────────────────────────────┐       │
     │   │         Determine compensated               │~S840  │
     │   │       first voltage value of battery        │       │
     │   └────────────────────┬───────────────────────┘       │
     └ ─ ─ ─ ─ ─ ─ ─ ─ ─ ─ ─ ─│─ ─ ─ ─ ─ ─ ─ ─ ─ ─ ─ ─ ─ ─ ─ ┘
                              ▼
                    ┌──────────┐
                    │   S720   │
                    └──────────┘
```

FIG. 9

```
                    ┌─────────────┐
                    │    Start    │
                    └──────┬──────┘
                           │
                           ▼
         ┌──────────────────────────────────────┐
         │ Determine first voltage value indicating │  ~S700
         │      no-load voltage of battery         │
         └──────────────────┬───────────────────┘
                           │
                           ▼
         ┌──────────────────────────────────────┐
         │ Compensate first voltage value of battery │  ~S710
         └──────────────────┬───────────────────┘
                           │
                           ▼
         ┌──────────────────────────────────────┐
         │    Determine reference voltage value    │  ~S720
         └──────────────────┬───────────────────┘
                           │
                           ▼
         ┌──────────────────────────────────────┐
         │ Determine voltage deviation of battery  │  ~S730
         └──────────────────┬───────────────────┘
                           │
                           ▼
         ┌──────────────────────────────────────┐
         │      Determine change amount of        │  ~S740
         │     voltage deviation of battery       │
         └──────────────────┬───────────────────┘
                           │
```

S910

Change amount of voltage deviation ≥ Threshold?

No → S922 Reset fault count of battery

Yes

S920 Increase fault count of battery by 1

S930

Fault count of battery ≥ Predetermined value?

No

Yes

S940 Detect internal short circuit fault in battery

End

26

REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- KR 1020210098141
- WO 2020021889 A1
- EP 3829023 A1
- JP 2019176637 A

**Non-patent literature cited in the description**

- Online multi-fault detection and diagnosis for battery packs in electric vehicles. **KANG YONGZHE et al.** Applied Energy. Elsevier Science publishers, 30 November 2019, vol. 259